Europäisches Patentamt

European Patent Office

Office européen des brevets

(19)

(11) Numéro de publication: **0 354 860**
**A1**

## DEMANDE DE BREVET EUROPEEN

(12)

(21) Numéro de dépôt: **89420289.4**

(22) Date de dépôt: **31.07.89**

(51) Int. Cl.5: **H 01 L 27/10**
H 01 L 29/788, G 11 C 17/00

(30) Priorité: **11.08.88 FR 8810965**

(43) Date de publication de la demande:
**14.02.90 Bulletin 90/07**

(84) Etats contractants désignés: **DE FR GB IT NL**

(71) Demandeur: **SGS-THOMSON MICROELECTRONICS S.A.**
**7, Avenue Galliéni**
**F-94250 Gentilly (FR)**

(72) Inventeur: **Bergemont, Albert**
**25, Chemin Pré Morin**
**F-38700 Corenc (FR)**

(74) Mandataire: **de Beaumont, Michel**
**1bis, rue Champollion**
**F-38000 Grenoble (FR)**

(54) **Mémoire de type éprom à haute densité d'intégration avec une organisation en damier, un facteur de couplage amélioré et une possibilité de rédondance.**

(57) La présente invention concerne une mémoire non-volatile électriquement programmable composée d'un réseau de lignes de mot (LM2) s'étendant suivant une première direction dite de rangée, et de lignes de bit (LB2 à LB4) s'étendant suivant une deuxième direction dite de colonne. Une zone conductrice (25) réalisée par un deuxième niveau de silicium polycristallin contacte et recouvre la grille flottante (23) de chaque transistor en débordant dans la direction des rangées. La zone conductrice (25) dans chaque transistor est en regard de la ligne de mot connectée au transistor, cette ligne de mot correspondant, à l'emplacement des zones conductrices, à la grille de commande (28).

Figure 6

EP 0 354 860 A1

## Description

## MEMOIRE DE TYPE EPROM A HAUTE DENSITE D'INTEGRATION AVEC UNE ORGANISATION EN DAMIER, UN FACTEUR DE COUPLAGE AMELIORE ET UNE POSSIBILITE DE REDONDANCE

La présente invention concerne les mémoires à semiconducteur, et plus particulièrement les mémoires non-volatiles électriquement programmables, plus couramment appelées mémoires EPROM ; la fabrication des mémoires à grille flottante est plus précisément concernée.

Pour obtenir des mémoires de grande capacité de stockage, par exemple des mémoires capables de stocker jusqu'à 16 mégabits, on doit réduire le plus possible la dimension de chacune des cellules constituant la mémoire.

Mais on est évidemment limité par des considérations physiques, et notamment par la finesse des motifs que permettent les étapes de photolithographie ; on est limité aussi par les paramètres électriques parasites qui sont dus au processus de fabrication et qui perturbent le fonctionnement de la mémoire.

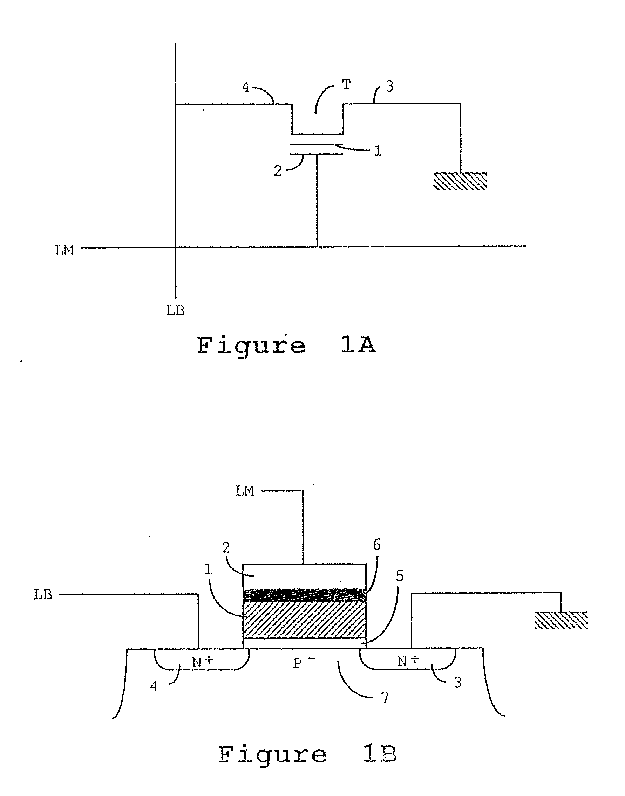

Un point-mémoire élémentaire de mémoire classique est représenté sur les figures 1A et 1B, la figure 1A étant une représentation sous forme de schéma électrique et la figure 1B étant une vue en coupe schématique du point-mémoire élémentaire.

La figure 1A représente un transistor T d'un point-mémoire à grille flottante. Ce transistor possède une grille flottante 1 et une grille de commande 2, ainsi que deux régions semiconductrices d'un premier type de conductivité (source 3 et drain 4) séparées par une région de canal d'un type de conductivité opposé recouverte par la grille flottante 1 et la grille de commande 2.

La grille de commande 2 est reliée à une ligne de mot LM. Le drain 4 est relié à une ligne de bit LB.

Pour programmer, ou écrire, un tel point-mémoire, on charge sa grille flottante 1 par injection de porteurs chauds, en appliquant à la grille de commande 2, pendant que le transistor conduit un courant entre ses régions de source 3, mises à la masse, et de drain 4, un potentiel suffisamment élevé pour que les porteurs de charge (électrons) soient attirés et piégés dans la grille flottante. Cette opération d'écriture a pour effet d'augmenter le seuil de conduction du transistor qui, une fois programmé, ne conduira le courant que pour des valeurs de potentiel appliqué sur la grille de commande plus élevées qu'en l'absence de programmation.

Lors de la lecture de l'information contenue dans un point-mémoire, on applique à la grille de commande du transistor de ce point-mémoire une tension à la fois supérieure à la tension de seuil de déclenchement de conduction à l'état non-programmé et inférieure à la tension de seuil de déclenchement de conduction à l'état programmé. Si le transistor conduit le courant quand une différence de potentiel adaptée est appliquée entre la source et le drain, le point-mémoire est à l'état non-programmé. Si le transistor ne conduit pas le courant, le point-mémoire est à l'état programmé.

Le potentiel appliqué à la grille de commande lorsqu'on programme le point-mémoire, ou potentiel de programmation Vpp, est par exemple de 15 volts. Le potentiel de drain Vcc est alors par exemple de 10 volts, et le potentiel de source Vss est par exemple zéro volt, ou la masse.

Le potentiel appliqué à la grille de commande lors de la lecture du point-mémoire est par exemple de 5 volts. Le potentiel de drain Vcc est alors par exemple de 1,5 volts, et le potentiel de source Vss est par exemple zéro volt, ou la masse.

Sur la figure 1B, qui représente une vue en coupe d'un point-mémoire implanté sur une tranche de silicium, on retrouve la grille flottante 1 et la grille de commande 2 du transistor. On voit également la source 3 et le drain 4, qui sont deux régions semiconductrices d'un premier type de conductivité, par exemple $N^+$, séparées par une région de canal 7 d'un type de conductivité opposé, par exemple $P^-$.

La grille flottante 1 du transistor est réalisée par un premier niveau de silicium polycristallin (poly 1). Elle est séparée du substrat par une couche de dioxyde de silicium 5, également appelée couche d'oxyde de grille.

Au-dessus de la grille flottante 1, on trouve une couche de dioxyde de silicium 6. Cette couche est située entre la grille flottante 1 et la grille de commande 2, cette dernière étant réalisée par un deuxième niveau de silicium polycristallin (poly 2). La couche de dioxyde de silicium 6 porte ainsi également le nom de couche d'oxyde interpoly.

Dans la mémoire, la grille de commande 2 du transistor est reliée à une ligne de mot LM. La source 3 est reliée à la masse, et le drain 4 à une ligne de bit LB.

Avec l'architecture de mémoire classique et le mode de programmation associé, il est impératif que le drain d'un transistor soit électriquement isolé, par de l'oxyde de silicium épais (comparativement à l'oxyde de grille des transistors), du drain des transistors adjacents de la même ligne de mot, faute de quoi on ne pourrait programmer un point-mémoire particulier sans programmer ou déprogrammer en même temps les autres.

Mais cet oxyde épais qui isole deux points adjacents occupe beaucoup de place, surtout lorsqu'il est réalisé par la technique dite d'oxydation localisée.

On a essayé de remplacer l'oxydation localisée par une isolation par tranchées remplies d'oxyde, pour réduire l'encombrement global de la cellule, mais cette technologie n'est pas industriellement au point.

Pour réduire l'encombrement des points-mémoire et ainsi augmenter la capacité de stockage de la mémoire, on a proposé dans la demande de brevet français 86/12938 des structures où les zones d'oxyde épais et les contacts multiples vers les drains ou sources sont supprimés. Ces structures sont appelées structures de type damier.

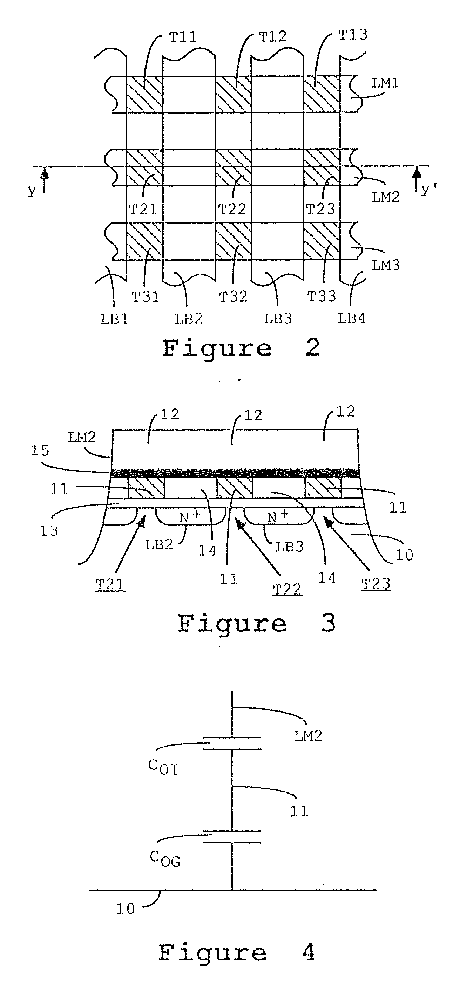

La figure 2 représente une vue de dessus de neuf points-mémoire adjacents dans un telle structure de type damier.

On désigne par Tij les différents transistors à grille flottante constituant le réseau de points-mémoire, où i est un indice de rangée et j un indice de colonne.

Ainsi, les transistors T11 à T13 sont ceux de la première rangée, les transistors T21 à T23 sont ceux de la deuxième rangée, et les transistors T31 à T33 sont ceux de la troisième rangée. De même, les transistors T11 à T31 sont ceux de la première colonne, les transistors T12 à T32 sont ceux de la deuxième colonne et enfin les transistors T13 à T33 sont ceux de la troisième colonne.

Les grilles de commande des transistors d'un même rangée sont toutes reliées à une même ligne de mot, LM1 à LM3 pour les rangées 1 à 3, respectivement.

Les lignes de mot sont des conducteurs (en pratique en silicium polycristallin) s'étendant selon une direction horizontale (direction des rangées).

Chaque transistor partage avec les deux transistors adjacents sur la même rangée une région réalisée par une diffusion du premier type de conductivité qui se prolonge suivant une colonne pour former une ligne de bit, que l'on désigne par LB1, LB2, LB3 et LB4 pour les colonnes 1 à 4, respectivement, et par LBj d'une façon générale. Ces lignes LBj peuvent ainsi faire, à l'emplacement des transistors, soit office de source, soit office de drain.

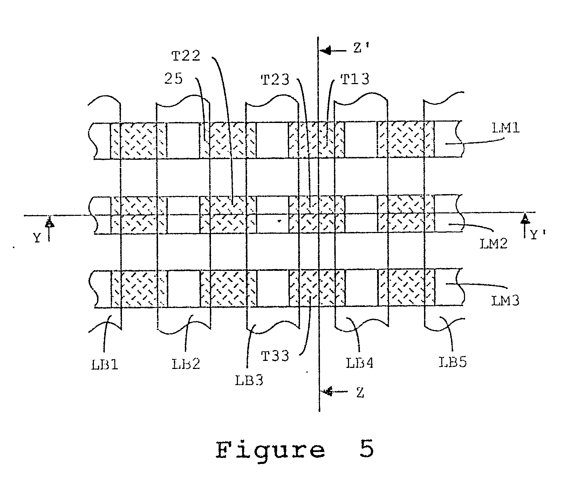

La figure 3 représente une vue en coupe suivant l'axe YY' de la figure 2.

Les dispositifs sont situés sur un substrat 10. Les grilles flottantes 11 des transistors sont réalisées par un premier niveau de silicium polycristallin (poly 1) et situées entre deux lignes de bit. Les grilles de commande 12 des transistors sont formées par les parties de la ligne de mot LM2 situées à l'emplacement des transistors. Les lignes de mot, et ainsi les grilles de commande des transistors, sont réalisées par un deuxième niveau de silicium polycristallin (poly 2).

Une couche d'oxyde de grille 13 est située sous la grille flottante des transistors.

Une zone d'isolement 14 est située entre les grilles flottantes des transistors. De façon classique, un procédé de planarisation est utilisé pour que les surfaces supérieures de cette zone d'isolement 14 et du premier niveau de silicium polycristallin soient au même niveau. Cette zone d'isolement 14 est par exemple constituée de tétraéthyle ortho silicate ou TEOS.

Une couche d'oxyde interpoly 15 recouvre les grilles flottantes 11 et les zones d'isolement 14.

Le mode de programmation de cette architecture est particulier. Il est exposé dans la demande de brevet français précitée. Cela est dû fait que chaque point-mémoire partage avec chacun des deux points-mémoire adjacents de la même rangée une région qui peut être soit région de source soit région de drain.

La figure 4 représente un schéma des capacités existant à l'emplacement d'un transistor, par exemple le transistor T22.

Si l'on applique une tension $V_M$ à la ligne de mot LM2, on obtient la tension $V_F$ sur la grille flottante 11 en calculant le facteur de couplage $\gamma$ qui relie ces deux tensions par la relation :

$$V_F = \gamma \, V_M$$

et qui est défini par le rapport entre la capacité au niveau de la couche d'oxyde interpoly et la somme de toutes les capacités présentes.

Si l'on considère la figure 4, on observe la capacité au niveau de la couche d'oxyde interpoly 15 notée $C_{OI}$ et située entre la ligne de mot LM2 et la grille flottante 11. On a aussi une capacité $C_{OG}$ au niveau de la couche d'oxyde de grille 13 située entre la grille flottante 11 et le substrat 10.

Le facteur de couplage $\gamma$ s'écrit :

$$\gamma = C_{OI}/(C_{OI} + C_{OG})$$

On peut calculer une valeur numérique représentative du facteur de couplage en utilisant des valeurs usuelles pour les dimensions des éléments concernés :
- longueur de la grille flottante suivant la direction des rangées : 0,5 micromètre ;
- épaisseur de la couche d'oxyde interpoly : 20 nm ;
- épaisseur de la couche d'oxyde de grille : 20 nm ;

La valeur numérique du facteur de couplage est alors égale au rapport entre les quantités 0,5/20 et 0,5/20 + 0,5/20, soit seulement 0,5.

La présente invention propose une nouvelle structure qui permet d'améliorer le facteur de couplage. De plus, cette nouvelle structure ne présente pas de zone d'oxyde épais, ce qui permet à la mémoire d'occuper un encombrement réduit.

Selon l'invention, la mémoire dont les points-mémoire sont constitués de transistors MOS à grille flottante est composée d'un réseau de lignes de mot s'étendant suivant une première direction dite de rangée, et de lignes de bit s'étendant suivant une deuxième direction dite de colonne. Dans cette mémoire, chaque transistor comprend deux régions faisant chacune office soit de source, soit de drain, chacune des deux régions est constituée par une diffusion d'un premier type de conductivité qui se prolonge suivant une colonne pour former une ligne de bit dans un substrat du deuxième type de conductivité, la grille flottante de chaque transistor est réalisée par un premier niveau de silicium polycristallin, et une zone d'isolement est située entre chaque paire de grilles flottantes d'une même rangée. Une zone conductrice réalisée par un deuxième niveau de silicium polycristallin contacte et recouvre suivant la direction des rangées la grille flottante de chaque transistor en débordant dans la direction des rangées. Les zones conductrices sont recouvertes sur leur surface supérieure d'une couche d'oxyde interpoly, et elles sont recouvertes à leurs deux extrémités, suivant la direction des rangées, par une zone d'oxyde de coin. Les lignes de mot, de dimensions suivant la direction des colonnes sensiblement égales à celles de la grille flottante des transistors et réalisées par un troisième niveau de silicium polycristallin, recouvrent les couches d'oxyde interpoly, les zones d'oxyde de coin et les parties de zones d'isolement non-recouvertes par les zones d'oxyde de coin. La zone conductrice dans chaque transistor est en regard de la ligne de mot connectée au transistor, cette ligne de mot correspondant, à l'emplacement des zones conductrices, à la grille de commande.

Ces objets, caractéristiques et avantages ainsi que d'autres de la présente invention seront exposés plus en détail dans la description suivante d'un mode de réalisation particulier faite en relation avec les figures jointes parmi lesquelles :

les figures 1A et 1B, déjà décrites, représentent un point-mémoire élémentaire de mémoire classique, la figure 1A étant une représentation sous forme de schéma électrique et la figure 1B étant une vue en coupe schématique du point-mémoire élémentaire ;

la figure 2, déjà décrite, représente une vue de dessus de l'implantation de neuf points-mémoire adjacents sur une tranche de silicium dans une architecture classique de type damier ;

la figure 3, déjà décrite, représente une vue en coupe suivant l'axe YY' de la figure 2 ;

la figure 4, déjà décrite, représente un schéma des capacités existant à l'emplacement d'un transistor dans une architecture telle que celle de la figure 2 ;

la figure 5 représente une vue de dessus d'une structure selon la présente invention ;

la figure 6 représente une vue en coupe suivant l'axe YY' de la figure 5 ;

la figure 7 représente une vue en coupe suivant l'axe ZZ' de la figure 5 ;

la figure 8 représente un schéma des capacités existant à l'emplacement d'un point-mémoire de la structure de la figure 5 ; et

la figure 9 représente selon une coupe analogue à celle de la figure 6 une variante de réalisation de la présente invention.

De façon générale, comme cela est classique dans la représentation des circuits intégrés, on notera que les diverses figures ne sont pas représentées à l'échelle ni d'une figure à l'autre, ni à l'intérieur d'une même figure, et notamment que les épaisseurs des couches sont dessinées arbitrairement dans le but de faciliter la lecture des figures.

La figure 5 représente une vue de dessus d'un mode de réalisation de la structure selon la présente invention. Comme dans le cas de la figure 2, les transistors sont disposés en réseau de rangées et colonnes.

Les grilles de commande des transistors de la rangée i sont encore toutes reliées à des lignes de mot LMi.

Les lignes de bit LBj sont situées entre chaque paire de colonnes de transistors et peuvent faire, à l'emplacement des transistors, soit office de source, soit office de drain.

Une zone conductrice 25 est en contact avec la grille flottante de chaque transistor de la mémoire.

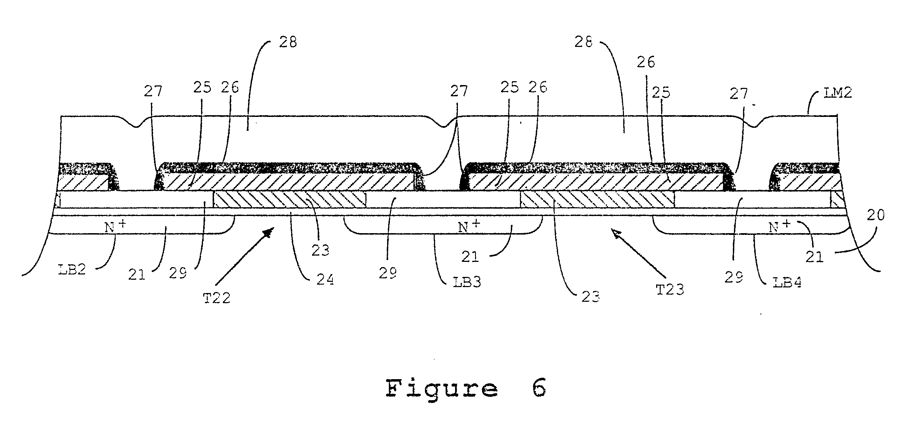

La figure 6 représente une vue en coupe suivant l'axe YY' de la figure 5. On voit sur cette figure deux transistors désignés par T22 et T23.

Les dispositifs sont situés sur un substrat 20. Chacun des deux transistors T22 et T23 comprend deux régions 21 constituées par une diffusion d'un premier type de conductivité qui se prolonge suivant une colonne pour former une ligne de bit. Ces lignes de bit sont désignées par LB2, LB3 et LB4 sur la figure.

Les grilles flottantes 23 des transistors sont réalisées par un premier niveau de silicium polycristallin (poly 1). Une couche d'oxyde de grille 24 est située sous les grilles flottantes des transistors.

Une zone conductrice 25 contacte et recouvre suivant la direction des rangées la grille flottante de chacun des deux transistors T22 et T23. Elle est réalisée par un deuxième niveau de silicium polycristallin (poly 2).

Cette zone conductrice 25 est recouverte sur sa surface supérieure par une couche d'oxyde interpoly 26, et elle est recouverte à ses extrémités, suivant la direction des rangées, par une zone d'oxyde 27 qui est appelée zone d'oxyde de coin.

Une zone d'isolement 29 est située entre les grilles flottantes des transistors. Comme dans le cas de la structure représentée sur la figure 3, un procédé de planarisation est utilisé pour que les surfaces supérieures de cette zone 29 et du premier niveau de silicium polycristallin soient au même niveau. Cette zone 29 est par exemple constituée de TEOS.

La ligne de mot LM2 recouvre l'ensemble.

La couche d'oxyde interpoly 26 et les zones d'oxyde de coin 27 permettent d'isoler la zone conductrice 25 de la ligne de mot LM2. La ligne de mot LM2 fait office de grille de commande 28 à l'emplacement des zones conductrices 25.

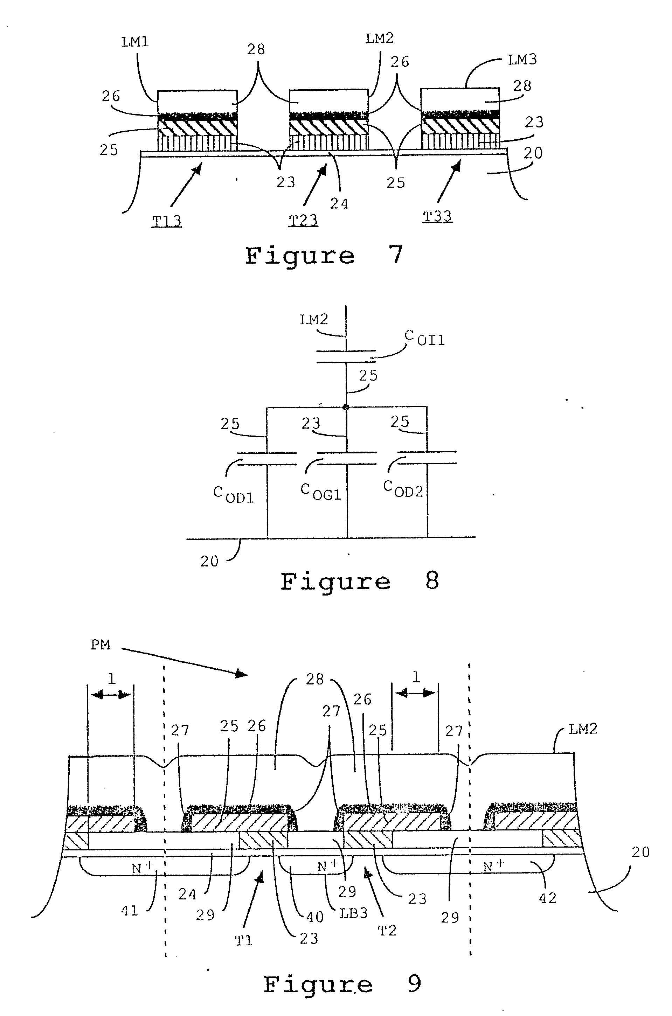

La figure 7 représente une vue en coupe suivant l'axe ZZ' de la figure 5. On voit sur cette figure des transistors désignés par T13, T23 et T33. Les transistors possèdent chacun une grille flottante 23 située au-dessus de la couche d'oxyde de grille 24. La zone conductrice 25 est placée au-dessus des grilles flottantes 23 et au-dessous de la couche d'oxyde interpoly 26. On observe également les lignes de mot LM1, LM2 et LM3, situées au-dessus des couches l'oxyde interpoly 26, qui font office de grille de commande 28 à l'emplacement des zones conductrices.

La figure 8 représente un schéma des capacités existant à l'emplacement d'un point-mémoire de la structure selon la présente invention, par exemple le point-mémoire comprenant le transistor T22. On observe sur cette figure la capacité au niveau de la couche d'oxyde interpoly 26 notée $C_{OI1}$ et située entre la ligne de mot LM2 et la zone conductrice 25. On a aussi une capacité $C_{OG1}$ au niveau de la couche d'oxyde de grille 24 située entre les grilles flottantes 23 et le substrat 20. Il existe également, puisque la zone conductrice 25 déborde de la grille flottante des transistors dans la direction des rangées, une capacité $C_{OD1}$ et une capacité $C_{OD2}$ au niveau de la zone d'isolement de type TEOS, chacune de ces deux capacités correspondant au débordement selon un côté.

Le facteur de couplage $\gamma$ s'écrit :
$$\gamma = C_{OI1}/(C_{OI1} + C_{OD1} + C_{OG1} + C_{OD2})$$
On peut calculer une valeur numérique représentative du facteur de couplage en utilisant les valeurs usuelles suivantes :

- longueur de la grille flottante suivant la direction des rangées : 0,5 micromètre ;
- longueur totale de débordement de la zone conductrice 25 (on regroupe ainsi les débordements de chaque côté de la grille flottante) : 0,2 micromètre ;
- épaisseur de la couche d'oxyde interpoly : 20 nm ;
- épaisseur de la couche d'oxyde de grille : 20 nm ;
- épaisseur de la zone d'isolement de type TEOS : 200 nm.

La valeur numérique du facteur de couplage est alors égale au rapport entre les quantités (0,5 + 0,2)/20 et (0,5 + 0,2)/20 + 0,5/20 + 0,2/(200 + 20).

Le facteur de couplage est alors égal à 0,58.

La structure selon l'invention permet ainsi d'améliorer le facteur de couplage.

Cette structure présente également de bonnes conditions de planarisation du fait de l'absence de zone d'oxyde épais.

Cependant, dans une telle structure, la programmation d'un point-mémoire doit tenir compte des points-mémoire adjacents. Cela rend le système d'adressage complexe.

La figure 9 représente, selon une coupe analogue à celle de la figure 6, et avec les mêmes références numériques chaque fois que cela était possible, une variante de réalisation de l'invention qui permet d'utiliser une section d'adressage classique.

Dans cette variante, on désigne par T1, T2 un couple de transistors adjacents qui vont être connectés par le système d'adressage pour constituer un point-mémoire PM unique. La mémoire a alors une structure dite en demi-damier.

Les diffusions en colonnes sont alors spécialisées. Les transistors T1 et T2 partagent une région de drain commune 40. Chacun des deux transistors T1 et T2 comprend une région de source 41, 42 partagée avec un transistor d'un point-mémoire adjacent de la même rangée. Les grilles flottantes 23, 25 des transistors T1, T2 sont adressées simultanément par le système d'adressage de la mémoire.

La structure en demi-damier présente une redondance. En effet, si la grille flottante de l'un des transistors perd sa charge, on pourra encore lire la charge présente sur la grille flottante de l'autre.

La structure observée sur la figure 9 présente d'autres avantages en plus de la grande sécurité résultant de la redondance.

En effet, si l'on adopte la configuration représentée en figure 9 avec un décalage (1) entre les portions de silicium polycristallin du deuxième niveau (poly 2) 25 et les grilles flottantes proprement dites 23, on peut former des régions de source 41, 42 plus larges que les régions de drain 40. Une augmentation de la largeur des régions de source entraîne une diminution de la résistance, ce qui a pour effet d'améliorer les caractéristiques de programmation.

Enfin, une ligne conductrice (non-représentée sur les figures), par exemple en aluminium, est classiquement située au-dessus de chaque ligne de bit. Dans le cas de la structure représentée sur la figure 6, une telle ligne conductrice est située entre chaque paire de colonnes de transistors. Dans le cas de la structure représentée sur la figure 9, deux colonnes de transistors séparent deux lignes conductrices adjacentes. L'élaboration des lignes conductrices sera ainsi plus facile à réaliser dans le deuxième cas.

**Revendications**

1. Mémoire dont les points-mémoire sont constitués de transistors MOS à grille flottante, composée d'un réseau de lignes de mot (LM1 à LM3) s'étendant suivant une première direction dite de rangée, et de lignes de bit (LB1 à LB5) s'étendant suivant une deuxième direction dite de colonne, dans laquelle :

chaque transistor comprend deux régions (21) faisant chacune office soit de source, soit de drain,

chacune des deux régions (21) est constituée par une diffusion d'un premier type de conductivité qui se prolonge suivant une colonne pour former une ligne de bit dans un substrat (20) du deuxième type de conductivité,

la grille flottante (23) de chaque transistor est réalisée par un premier niveau de silicium polycristallin,

une zone d'isolement (29) est située entre chaque paire de grilles flottantes d'un même rangée,

caractérisée en ce que :

une zone conductrice (25) réalisée par un deuxième niveau de silicium polycristallin contacte et recouvre suivant la direction des rangées la grille flottante de chaque transistor en débordant dans la direction des rangées,

les zones conductrices sont recouvertes sur leur surface supérieure d'une couche d'oxyde interpoly (26), et elles sont recouvertes à leurs deux extrémités, suivant la direction des rangées, par une zone d'oxyde de coin (27),

les lignes de mot, de dimensions suivant la direction des colonnes sensiblement égales à celles de la grille flottante des transistors et réalisées par un troisième niveau de silicium polycristallin, recouvrent les couches d'oxyde interpoly, les zones d'oxyde de coin et les parties de zones d'isolement non-recouvertes par les zones d'oxyde de coin, et

la zone conductrice dans chaque transistor est en regard de la ligne de mot connectée au transistor, cette ligne de mot correspondant, à l'emplacement des zones conductrices, à la grille de commande (28).

2. Mémoire selon la revendication 1, caractérisée en ce qu'elle est connectée à une partie logique d'adressage de mémoire de type demi-damier.

3. Mémoire selon l'une des revendications 1 ou 2, caractérisée en ce que les diffusions constituant les régions de source à l'emplacement des transistors ont une largeur plus importante que la largeur des diffusions constituant les régions de drain à l'emplacement des transistors.

Figure 1A

Figure 1B

T11    T12    T13

LM1

Y                                          LM2    Y'

T21    T22    T23

LM3

T31    T32    T33

LB1    LB2    LB3    LB4

# Figure    2

12          12          12

LM2

15

11

13

N⁺          N⁺          11

LB2    14    LB3    14    10

T21          11    T22    14    T23

# Figure    3

LM2

$C_{OI}$

11

$C_{OG}$

10

# Figure    4

Figure 5

Figure 6

EP 0 354 860 A1

LM1     28     LM2     26     LM3

26     28

25     23

23     25     20

T13     T23     24     T33

## Figure 7

LM2

$C_{OI1}$

25

25     23     25

$C_{OD1}$     $C_{OG1}$     $C_{OD2}$

20

## Figure 8

PM

l     28     l

27     26

27     25   26     27     25     27     LM2

$N^+$     $N^+$     $N^+$     20

41     24     29     40     LB3     23     29     42

29     T1     23     T2

## Figure 9

Office européen
des brevets

**RAPPORT DE RECHERCHE EUROPEENNE**

Numero de la demande

EP 89 42 0289

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 258 466 (KUO et al.) <br> * Colonne 2, ligne 1 - colonne 3, ligne 7; figures 1-3d * <br> --- | 1 | H 01 L 27/10 <br> H 01 L 29/788 <br> G 11 C 17/00 |
| A | EP-A-0 197 284 (FUJITSU LTD) <br> * Colonne 8, ligne 1 - colonne 11, ligne 21; figures 4A-4D * <br> --- | 1 | |
| A | DE-A-3 426 306 (MUTSUBISHI DENKI K.K.) <br> * Figure 2G * <br> --- | 1 | |
| A | EP-A-0 087 155 (K.K. TOSHIBA) <br> * Résumé; figure 6 * <br> ----- | 1 | |

**DOMAINES TECHNIQUES RECHERCHES (Int. Cl.5)**

H 01 L

Le présent rapport a été établi pour toutes les revendications

| Lieu de la recherche | Date d'achèvement de la recherche | Examinateur |
|---|---|---|
| LA HAYE | 15-11-1989 | BAILLET B.J.R. |